Europäisches Patentamt

European Patent Office

Office européen des brevets

(11) Veröffentlichungsnummer: **0 332 087**
**A1**

(12) **EUROPÄISCHE PATENTANMELDUNG**

(21) Anmeldenummer: 89103805.1

(22) Anmeldetag: 03.03.89

(51) Int. Cl.⁴: **H04L 27/12 , H03C 3/09**

(30) Priorität: 09.03.88 DE 3807778

(43) Veröffentlichungstag der Anmeldung:
**13.09.89 Patentblatt 89/37**

(84) Benannte Vertragsstaaten:
**DE FR GB IT NL SE**

(71) Anmelder: **Siemens Aktiengesellschaft**
**Wittelsbacherplatz 2**
**D-8000 München 2(DE)**

(72) Erfinder: **Beyrich, Heinrich, Dipl.-Ing. (FH)**
**Plettstrasse 7**
**D-8000 München 83(DE)**
Erfinder: **Tanner, Reiner**
**Rasso-Strasse 1**
**D-8082 Grafrath(DE)**

(54) **Frequenzmodulator.**

(57) Der Frequenzmodulator ist geeignet zur Frequenzmodulation eines Hochfrequenzträgers mit insbesondere digitalen Modulationssignalen. Er besteht aus einem spannungsgesteuerten Oszillator (VCO) (3), der hinsichtlich seiner frequenzmodulierten Ausgangsfrequenz durch eine Bezugsschwingung mit Hilfe einer Phasenregelschleife, bestehend aus einem Frequenzvervielfacher (4), einem vom Modulationssignal und vom Hochfrequenzsignal gesteuerten Swallow-Frequenzteiler (5), einem Addierer (11) für die Modulations- und Regelspannung, einem Regelspannungsfilter (10) und einem Phasenvergleicher (9), stabilisiert wird. Das Modulationssignal wird über ein Modulationsfilter (1) einmal einer Steuerschaltung (12) für den Swallow-Frequenzteiler und zum anderen einem Pegeleinsteller (2) vor dem Addierer (11) zugeführt. Damit werden entsprechend der augenblicklichen Amplitude des Modulationssignals sowohl der VCO direkt durch das Modulationssignal als auch indirekt durch die Umschaltung des Swallow-Frequenzteilers und damit durch die Regelspannung mit dem gewünschten Frequenzhub moduliert.

FIG 1

EP 0 332 087 A1

## Frequenzmodulator

Die Erfindung bezieht sich auf einen Frequenzmodulator, der hinsichtlich seiner Ausgangsfrequenz durch eine Bezugsschwingung über eine Phasenregelschleife stabilisiert ist. Ein solcher Frequenzmodulator ist beispielsweise durch die DE-PS 29 14 814 bekannt.

Die direkte Frequenzmodulation von Datensignalen erfordert die Umwandlung von binären oder mehrwertigen Zeichen in definierte Frequenzabweichungen eines Hochfrequenzträgers von seiner Mittenfrequenz. Vom phasengeregelten Frequenzmodulator wird dabei verlangt, daß die Mittenfrequenz und möglichst auch die von der Modulation verursachten Frequenzabweichungen, die als Frequenzhub bezeichnet werden, an eine Referenzfrequenz angebunden werden und damit deren Frequenzgenauigkeit erreichen. Diese Anforderungen sind bei phasengeregelten Modulatoren insbesondere dann schwer zu erfüllen, wenn das Datensignal auch sehr tieffrequente Zeichenwechsel aufweist oder dessen Gleichstrommittelwert nicht Null ist, wie das bei vielen Datencodes der Fall ist. Das liegt daran, daß bei Einkopplung des Modulationssignals in einen spannungsgesteuerten Osziallator eines Phasenregelkreises die so vorgenommene Frequenzmodulation vom Phasenregelkreis trotz entsprechender Vorkehrungen teilweise als Störung erkannt und in unerwünschter Weise beeinflußt wird. Gleichstromanteile des Modulationssignals führen dann zu Mittenfrequenzverschiebungen des HF-Trägers oder tieffrequente Signalteile werden mehr oder weniger unterdrückt. Um diese Modulatoren trotzdem einsetzen zu können, ist der nachteilige Übergang auf gleichstromfreie und damit bitratenerhöhende Codes notwendig.

Der Erfindung liegt die Aufgabe zugrunde, einen phasengeregelten Frequenzmodulator für digitale Modulationssignale zu schaffen, mit dem diese Probleme in einfacher Weise gelöst werden. Klu 1 Hfe · 17.02.1988

Diese Aufgabe wird gemäß der Erfindung mit einem Frequenzmodulator der einleitend beschriebenen Art in der Weise gelöst, daß innerhalb der Phasenregelschleife die Frequenz des spannungsgesteuerten Oszillators (VCO) in einem Frequenzvervielfacher vervielfacht und anschließend durch einen Swallow-Frequenzteiler bis zur Referenzfrequenz des Phasenvergleichers heruntergeteilt und in diesem mit der Referenzfrequenz verglichen und mittels eines Netzwerkes mit einem bestimmten Amplituden- und Phasenfrequenzgang in eine Regelspannung umgewandelt und einem mit dem Steuereingang des Oszillators verbundenen Addierer zugeführt wird, auf den zugleich das über ein frequenzbandbegrenzendes und überschwingfreies Tiefpaßfilter und einen Amplitudeneinsteller geleitete Modulationssignal gleichstromgekoppelt gegeben wird und daß das Modulationssignal vom Tiefpaßfilterausgang aus auch einer Steuerschaltung zugeführt wird, die einen steuerbaren Frequenzteiler des Swallow-Frequenzteilers entsprechend der augenblicklichen Amplitude des Modulationssignals und des gewünschten Frequenzhubs umschaltet.

Swallow-Frequenzteiler sind durch Aufsätze in der Funkschau 8/1983, Seiten 73 bis 76 ("Der Synthesizer") und Fairchild "Progress" 8/1975, Seiten 10 bis 12 ("Pulse Swallowing Revisited") bekannt.

Durch die erfindungsgemäßen Maßnahmen wird erreicht, daß zum einen die direkte Frequenzmodulation mit beliebig zusammengesetzten Digitalsignalen durch die Phasenregelschleife möglichst ungestört bleibt und zum anderen die gewünschte Stabilisierung des Frequenzhubes und der Mittenfrequenz des spannungsgesteuerten Oszillators durch die Regelschleife erfolgt und außerdem die Modulationsfrequenz höher als der Frequenzhub gewählt werden kann. Das ergibt sich hauptsächlich durch den Frequenzvervielfacher, die gleichstromgekoppelte und im Pegel bestimmte Einspeisung des Modulationssignals in den VCO und die Anordnung des Modulationstiefpasses am Modulationseingang. Darauf wird im folgenden näher eingegangen. Die Steuerung des Frequenzteilers durch das Modulationssignal kann nicht ideal erfolgen, da dieser prinzipiell frühestens nach einer Periode des Bezugssignals auf einen neuen Teilungsfaktor umgestellt werden kann. Wechselt das Modulationssignal während dieser Zeit seinen Zustand, so ergibt sich für die Zeit vom Modulationszeichenwechsel bis zum Periodenende des Bezugssignals ein falsches Teilungsverhältnis für den Frequenzteiler und somit eine Störgröße im Regelkreis und damit in der Modulation. Diese Störgröße wird umso größer, je kleiner das Verhältnis von Bezugssignalfrequenz zu Modulationsfrequenz gewählt wird. Ohne den Frequenzvervielfacher würde die Schaltung bereits bei einem Verhältnis von 1 vollkommen versagen. Durch den Frequenzvervielfacher wird die durch das nicht ideale Umschalten des Frequenzteilers hervorgerufene Störung der Modulation um den Vervielfachungsfaktor verbessert. Das ergibt sich daraus, daß die Bezugssignalfrequenz um den Vervielfachungsfaktor höher gelegt werden kann und damit die Zeit zwischen Soll und Istwert der Umschaltung des Frequenzteilers um den gleichen Faktor verringert wird. Bei einer gleichstromfreien Einkopplung des Modulationssignals in den Phasenregelkreis würde der Gleichstromanteil im modulierten Signal allein durch den vom Modulationssignal gesteuerten Frequenzteiler erzeugt. Da aber, wie vorher dargelegt, die Frequenzteilersteuerung nicht vollkommen fehlerfrei realisiert werden kann, würden sich entsprechend zusätzlich unerwünschte Störungen des modulierten Signals ergeben. Die Regelzeitkonstante des Phasenregelkreises müßte dann ausschließlich nach der Änderungsgeschwindigkeit des Gleichstromwertes des Modulationssignals gewählt werden. Die gleichstromgekoppelte Einspeisung des Modulationssignals in den Phasenregelkreis vermeidet diesen Nachteil und ermöglicht es, die Regelkonstante des Phasenregelkreises allein hinsichtlich der durch die Umschaltung des Frequenzteilers verbleibenden Reststörung zu optimieren. Für die richtige Funktion der Schaltung muß der durch das Modulationssignal im VCO und der in der gesteuerten Frequenzteilerschaltung erzeugte Frequenzhub gleich sein. Andernfalls treten Frequenzhubänderungen bei unterschiedlich lang andauernden Modulationssignalzuständen auf. Deshalb ermöglicht die erfindungsgemäße Schaltung den notwendigen Abgleich des Frequenzhubs, der durch die direkte Frequenzmodulation des VCO mittels Umod entsteht nach der Bedingung $\Delta f = Fref \cdot \Delta A/V$.

Ferner werden durch die Anordnung des Modulationstiefpasses vor die Signalaufteilung in die beiden Modulationszweige unterschiedliche Signallaufzeiten in diesen und damit zusätzliche Störungen vermieden. Bei der Verwendung des Frequenzmodulators sowohl für digitale als auch für analoge Modulationssignale wird in den Zeitabschnitten der analogen Modulation der steuerbare Frequenzteiler auf ein festes Teilungsverhältnis entsprechend der Trägermittenfrequenz geschaltet. Dies für analoge Sprachsignale oder Tonsignale möglich, weil dafür keine gleichstromgekoppelte Übertragung erforderlich ist.

Der erfindungsgemäße Frequenzmodulator ist sowohl für digitale als auch für analoge Modulationssignale verwendbar, was ihn für einen Mischbetrieb, wie er z. B. im Netz-C (Mobiltelefon) gegeben ist, besonders interessant macht. Dabei wird in den Zeitabschnitten der analogen Modulation der steuerbare Frequenzteiler des Swallow-Frequenzteilers auf ein festes Teilungsverhältnis entsprechend der Trägermittenfrequenz geschaltet.

Nachstehend wird die Erfindung anhand eines in der Zeichnung dargestellten Ausführungsbeispiels näher erläutert.

Es zeigen

Fig. 1 einen Frequenzmodulator im Blockschaltbild und

Fig. 2 einen Swallow-Frequenzteiler mit Vervielfacher im Block schaltbild.

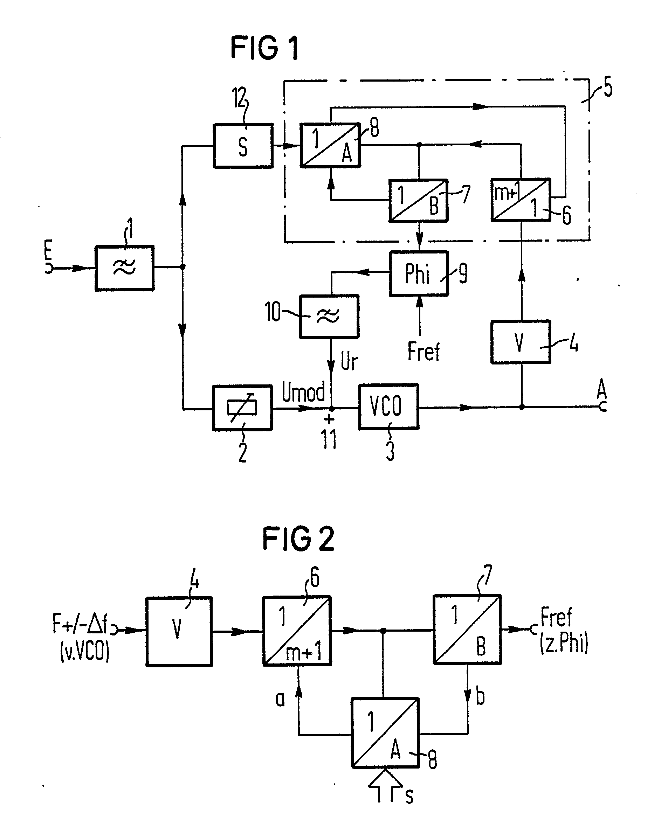

Beim Frequenzmodulator nach Fig. 1 ist der Modulator-Eingang mit E, der HF-Ausgang mit A bezeichnet. Im Eingangsweg liegt ein frequenzbandbegrenzendes und überschwingfreies Tiefpaßfilter (Modulationstiefpaß) 1. Am Ausgang dieses Modulationstiefpasses 1 erfolgt eine Signalaufteilung, wobei in dem einen Signalweg ein Amplitudeneinsteller 2, ein Addierer 11 und ein spannungsgesteuerter Oszillator (VCO) 3 angeordnet sind, der mit dem HF-Ausgang A verbunden ist. Der Oszillator 3, ein Frequenzvervielfacher 4, der Swallow-Frequenzteiler 5, ein Phasenvergleicher 9 und das Netzwerk 10 mit einem bestimmten Amplituden- und Phasenfrequenzgang bilden eine Phasenregelkreis. Der Swallow-Frequenzteiler 5, der in Fig. 2 in einer Einzeldarstellung gezeigt ist, besteht aus einem Vorteiler 6, einem Hauptteiler 7 und einem Steuerteiler 8, der von einer im zweiten Signalweg liegenden Steuerschaltung angesteuert und entsprechend der augenblicklichen Amplitude des Modulationssignals und des gewünschten Frequenzhubs umgeschaltet wird. Der Vorteiler 6 mit den umschaltbaren Teilungsfaktoren m und m + 1 ist mit dem Frequenzvervielfacher 4 verbunden, dessen Vervielfachungsfaktor V beträgt. Ein zweiter Eingang des Vorteilers 6 ist mit dem Steuerteiler 8 verbunden, dessen Teilungsfaktor A ist. Ausgangsseitig ist der Vorteiler 6 mit dem Hauptteiler 7 (Teilungsfaktor B) und dem Steuerteiler 8 verbunden. Ein erster Ausgang des Hauptteilers 7 ist mit dem Steuerteiler 8, ein zweiter Ausgang mit dem Phasenvergleicher 9 verbunden, an dem zugleich die Referenzfrequenz Fref anliegt.

Die erfindungsgemäße Schaltung funktioniert wie folgt: Die Frequenz des spannungsgesteuerten Oszillators (VCO) 3 wird im Frequenzvervielfacher 4 vervielfacht und dann durch den Swallow-Frequenzteiler 5 bis zur Referenzfrequenz Fref des Phasenvergleichers 9 heruntergeteilt, im Phasenvergleicher 9 mit der Referenzfrequenz Fref verglichen und mit Hilfe des Netzwerkes 10 in eine Regelspannung Ur umgewandelt und dem Addierer 11 zugeführt. Das Modulationssignal wird über das Tiefpaßfilter 1 und den Amplitudeneinsteller 2 zum Addierer 11 gleichstromgekoppelt geführt und außerdem auch der Steuerschaltung 12 zugeführt, die den programmierbaren Frequenzteiler (Steuerteiler) 8 des Swallow-Frequenzteilers 5 entsprechend der augenblicklichen Amplitude des Modulationssignals und des gewünschten Frequenzhubs umschaltet. Das Ausgangssignal des Addierers 11, in dem eine Summierung der Regelspannung Ur und des Modulationssignals Umod erfolgt, wird dem Steuereingang des Oszialltors 3 zugeführt, an dessen Ausgang das modulierte HF-Signal zur Verfügung steht.

Im Blockschaltbild nach Fig. 2, das den Swallow-Frequenzteiler mit Vervielfacher zeigt, sind mit a das Umschaltsignal für den Teilungsfaktor im Vorteiler 6, mit b das Freigabesignal für den Steuerteiler 8 und mit s vom Modulationssignal abgeleitete Umschaltsignale für den Steuerteiler 8 bezeichnet.

Der Zusammenhang zwischen der Trägerfrequenz F mit dem Frequenzhub +/- $\Delta$ f am Ausgang des VCO und dem Vervielfachungsfaktor V der Teilungsfaktoren des Swallow-Frequenzteilers A +/- $\Delta$ A,B,m sowie der Referenzfrequenz Fref ergibt sich aus

F +/- $\Delta$ f = (A +/- $\Delta$ A + m x B) x Fref / V

mit $\Delta$ f = $\Delta$ A x Fref / V

oder Fref = V x $\Delta$ f / $\Delta$ A

Daraus folgt z. B. für $\Delta$ A = V = 1

$\Delta$ f = Fref

und z. B. für $\Delta$ A = 1 und V > 1

$\Delta$ f < Fref

## Ansprüche

1. Frequenzmodulator, bestehend aus einem in seiner Frequenz modulierbaren Oszillator (VCO), der hinsichtlich seiner Ausgangsfrequenz durch eine Bezugsschwingung über eine Phasenregelschleife stabilisiert ist,

**dadurch gekennzeichnet,** daß innerhalb der Phasenregelschleife die Frequenz des spannungsgesteuerten Oszillators (VCO) in einem Frequenzvervielfacher vervielfacht und anschließend durch einen Swallow-Frequenzteiler bis zur Referenzfrequenz des Phasenvergleichers heruntergeteilt und in diesem mit der Referenzfrequenz verglichen und mittels eines Netzwerkes mit einem bestimmten Amplituden- und Phasenfrequenzgang in eine Regelspannung umgewandelt und einem mit dem Steuereingang des Oszillators verbundenen Addierer zugeführt wird, auf den zugleich das über ein frequenzbandbegrenzendes und überschwingfreies Tiefpaßfilter und einen Amplitudeneinsteller geleitete Modulationssignal gleichstromgekoppelt gegeben wird. und daß das Modulationssignal vom Tiefpaßfilterausgang aus auch einer Steuerschaltung zugeführt wird, die einen steuerbaren Frequenzteiler des Swallow-Frequenzteilers entsprechend der augenblicklichen Amplitude des Modulationssignals und des gewünschten Frequenzhubs umschaltet.

2. Frequenzmodulator nach Anspruch 1, **dadurch gekennzeichnet,** daß bei seiner Verwendung für analoge Modulationssignale der steuerbare Frequenzteiler auf ein festes Teilungsverhältnis entsprechend der Trägermittenfrequenz geschaltet wird.

# FIG 1

# FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | GB-A-2 046 541 (SIEMENS AG) * Figur 1 * & DE-C-2 914 814 (Kat. D) --- | 1 | H 04 L 27/12 H 03 C 3/09 |
| Y | WO-A-8 203 477 (MOTOROLA INC.) * Zusammenfassung; Figuren 1,2; Seite 3, Zeilen 1-18,22-24; Seite 71, Zeile 24 - Seite 72, Zeile 17; Anspruch 1 * --- | 1 | |
| A | GB-A-2 160 037 (MULTITONE ELECTRONICS PLC) * Zusammenfassung; Figur 1 * ----- | 1,2 | |

| RECHERCHIERTE SACHGEBIETE (Int. Cl.4) |
|---|
| H 04 L H 03 C |

Der vorliegende Recherchenbericht wurde für alle Patentansprüche erstellt

| Recherchenort | Abschlußdatum der Recherche | Prüfer |
|---|---|---|
| DEN HAAG | 18-05-1989 | VEAUX,C.J. |